# EUROPÄISCHE PATENTSCHRIFT

(11) **EP 0 756 710 B1**
(45) Veröffentlichungstag und Bekanntmachung des Hinweises auf die Patenterteilung: **04.03.1998**
(21) Anmeldenummer: 95917337.8
(22) Anmeldetag: 19.04.1995
(51) Int. Cl.: G01R 19/165, G01R 19/155

(54) **VORRICHTUNG ZUR ANZEIGE DER SPANNUNG EINES LEITERS EINES HOCHSPANNUNGSENERGIEVERSORGUNGSSYSTEMS**
DEVICE FOR DISPLAYING THE VOLTAGE OF A CONDUCTOR OF A HIGH-VOLTAGE POWER SUPPLY SYSTEM
DISPOSITIF POUR AFFICHER LA TENSION D'UN CONDUCTEUR D'UN SYSTEME D'ALIMENTATION EN ENERGIE HAUTE TENSION

(30) Priorität: 20.04.1994 DE 4413697
(43) Veröffentlichungstag der Anmeldung: 05.02.1997
(73) Patentinhaber: KARL PFISTERER ELEKTROTECHNISCHE SPEZIALARTIKEL GMBH & CO. KG, 70327 Stuttgart (DE)
(72) Erfinder: FISCHER, Gottfried, D-70599 Stuttgart (DE); GRUBER, Dieter, D-89231 Neu-Ulm (DE); SCHUSTER, Martin, D-73733 Esslingen (DE)
(74) Vertreter: Patentanwälte Bartels und Partner
(86) Internationale Anmeldenummer: EP9501468
(87) Internationale Veröffentlichungsnummer: WO9529407

(56) Entgegenhaltungen:
- EP-A- 0 438 689
- FR-A- 2 689 248

## Beschreibung

Die Erfindung betrifft eine Vorrichtung zur Anzeige der Spannung eines Leiters eines Hochspannungsenerrgieversorgungssystems, an den ein Sensor kapazitiv angekoppelt ist, mit einem Spannungsanzeigegerät, dem die Ausgangsspannung des Sensors über eine Schaltungsanordnung zugeführt wird und das einen Energiespeicher mit vorgeschaltetem Gleichrichter, einen elektrisch steuerbaren Schalter, der am Ende der Entladung des Energiespeichers in den Sperrzustand übergeht, und eine Blinksignale erzeugende Lichtquelle aufweist, wobei die Lichtquelle über den Schalter mit dem Energiespeicher verbunden ist.

Bei den bekannten Vorrichtungen dieser Art (DE-A-4109943) hängt die Blinkfrequenz der Lichtquelle von der Ausgangsspannung des Sensors ab, da der Schalter beim Erreichen einer vorbestimmten Ausgangsspannung des Energiespeichers, der durch einen Kondensator gebildet wird, in den leitenden Zustand übergeht und der Ladevorgang des Energiespeichers mit zunehmender Ausgangsspannung des Sensors immer kürzer wird. Da der Energiebedarf der als Lichtquelle verwendeten Lampe im Vergleich zu dem Strom, den der Sensor zu liefern vermag, groß ist, ergibt sich bei einer geringen Ausgangsspannung des Sensors eine relativ niedrige Blinkfrequenz, die zu einer Fehlinterpretation führen kann. Nachteilig ist ferner die relativ geringe Leuchtkraft der Lichtquelle, weil zur Vermeidung von sehr niedrigen Blinkfrequenzen die Ausgangsspannung des Energiespeichers niedrig gewählt werden muß, bei welcher der Schalter geschlossen und der Energiespeicher entleert wird.

Bei einer anderen bekannten Vorrichtung zur Anzeige der Spannung eines Leiters eines Energieversorgungssystemes, an den ein Sensor kapazitiv angekoppelt ist (FR-A-2 689 248), wird die Ausgangsspannung des Sensors über eine Diode einem als Energiespeicher dienenden Kondensator zugeführt. Sobald die Spannung dieses Kondensators die Zündspannung einer Neonlampe erreicht hat, entlädt sich der Kondensator über diese Neonlampe und einen mit ihr in Reihe liegenden Widerstand. Da die Leuchtkraft der Neonlampe sehr gering ist, wird vorgeschlagen, das an dem der Neonlampe nachgeschalteten Widerstand abgreifbare Impulssignal mit Hilfe einer Batterie und eines Verstärkers so weit zu verstärken, daß eine ausreichend helle Lichtquelle, beispielsweise eine Leuchtdiode, oder auch ein Relais betrieben werden kann. Der Nachteil, daß die Blinkfrequenz von der Ausgangsspannung des Sensors abhängig ist, ist hierdurch jedoch nicht beseitigt.

Bekannt ist ferner eine Signaleinrichtung zur Anzeige des Fehlens einer elektrischen Spannung (EP-A-0 438 689). Die Signaleinrichtung enthält eine Schwingschaltung, die nur dann aktiviert wird, wenn die zu überwachende Spannung verschwindet. Die Schwingschaltung enthält einen triggerbaren, über ein RC-Glied ansteuerbaren elektronischen Schalter. Da die Zeit, die benötigt wird, um den Kondensator des RC-Gliedes bis auf die Triggerspannung des elektronischen Schalters aufzuladen, von der Spannung eines Speicherkondensators abhängt, der nicht nur den Ladestrom, sondern auch die Energie für den Betrieb der Schwingschaltung und der nachgeschalteten Verstärkerschaltung sowie eines akustischen Signalgebers liefert, nimmt die Signalfrequenz umso mehr ab, je mehr sich der Speicherkondensator entlädt.

Der Erfindung liegt die Aufgabe zugrunde, eine verbesserte Vorrichtung der eingangs genannten Art zu schaffen. Diese Aufgabe löst eine Vorrichtung mit den Merkmalen des Anspruches 1.

Dadurch, daß der Schalter nicht mehr von der Ausgangsspannung des Energiespeichers, sondern von einer Auswertelogik gesteuert wird, kann die Blinkfrequenz der Lichtquelle über den gesamten Spannungsbereich konstant gehalten werden. Da außerdem die Auswertelogik erst oberhalb eines unteren Grenzwertes der Ausgangsspannung des Gleichrichters den Schalter ansteuert, kann das optische Signal, das die Lichtquelle erzeugt, nicht falsch interpretiert werden. Abhängig von der Spannung des Leiters des Hochspannungsenergieversorgungsnetzes ist nur die Helligkeit des optischen Signales, da die Energie, die im Energiespeicher für jeden Blinkvorgang gespeichert wird, um so größer ist, je höher die Spannung des Leiters des Hochspannungsenergieversorgungssystems und damit die Ausgangsspannung des Sensors ist.

Besonders vorteilhaft ist die Verwendung einer Leuchtdiode als Lichtquelle, da bei dieser die Lichtausbeute günstiger ist als bei den bisher verwendeten Lampen.

Bei einer bevorzugten Ausführungsform erfolgt die Verbindung zwischen dem Spannungsanzeigegerät und dem Sensor über ein Schnittstellenmodul mit einem geschlossenen Gehäuse, welches mit zwei Steckbuchsen versehen ist, in welche zwei Steckerstifte des Spannungsanzeigegerätes eingesteckt werden. Da diese Steckbuchsen extrem gut isolierend sein müssen, sind sie bei einer bevorzugten Ausführungsform gegenüber der den Zugang zu ihnen gestattenden Frontseite des geschlossenen Gehäuses zurückversetzt im Gehäuse angeordnet, wobei je ein Kanal sich von der Frontseite zur Steckbuchse erstreckt. Die Wandfläche dieser Kanäle bildet eine sich zur Steckbuchse hin verjüngende, konische Dichtungsfläche, an der bei hergestellter Steckverbindung eine entsprechend konische Außenmantelfläche einer den Steckerstift auf einem Teil seiner Länge umgebenden Materialpartie aus Isoliermaterial unter Bildung einer elektrischen Dichtung anliegt.

Vorzugsweise sind in das geschlossene Gehäuse des Schnittstellenmoduls nicht nur die Steckbuchsen und die Bauelemente der in diesem Gehäuse enthaltenen Schaltungsanordnung eingebettet, sondern auch der eine Endabschnitt eines Koaxialkabels und einer Erdungsleitung. Hierdurch sind alle spannungführenden Teile zuverlässig vor äußeren Störeinflüssen geschützt und eine hochwertige und dauerhafte Isolation dieser Teile gewährleistet. Das Schnittstellenmodul, das am anderen Ende des Koaxialkabels einen Verbindungsstecker hat, mit dem die Verbindung zum Sensor hergestellt wird, vereinfacht ferner die Installation.

Im folgenden ist die Erfindung anhand eines in der Zeichnung dargestellten Ausführungsbeispiels im einzelnen erläutert. Es zeigen:
- Fig. 1: eine Draufsicht auf das Spannungsanzeigegerät,
- Fig. 2: einen Längsschnitt des Spannungsanzeigegerätes,
- Fig. 3: eine Frontansicht des Spannungsanzeigegerätes,
- Fig. 4: eine Ansicht der Rückseite des Spannungsanzeigegerätes,
- Fig. 5: ein Blockschaltbild des Spannungsanzeigegerätes,
- Fig. 6: eine Draufsicht entsprechend Fig. 1 auf das Schnittstellenmodul,
- Fig. 7: eine unvollständig dargestellte Seitenansicht des Schnittstellenmoduls mit eingesetztem Spannungsanzeigegerät,
- Fig. 8: einen Längsschnitt des geschlossenen Gehäuses des Schnittstellenmoduls,
- Fig. 9: eine Frontansicht des Schnittstellenmoduls im montierten Zustand.

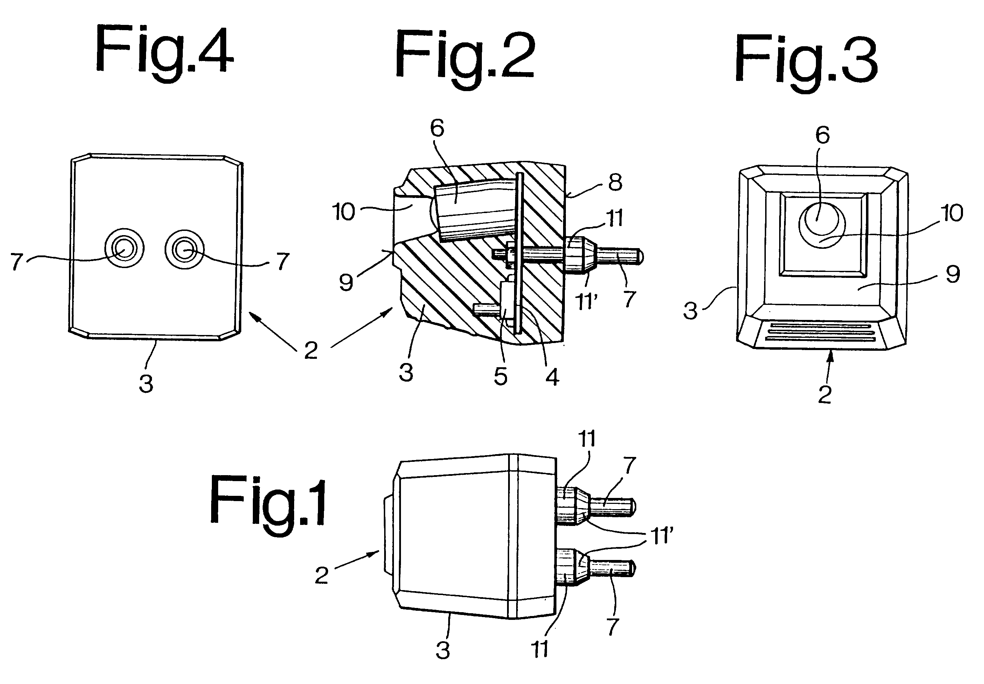

Zur Anzeige der Spannung eines Leiters eines Hochspannungsenergieversorgungssystemes, insbesondere eines isolierten Leiters eines solchen Systemes, an den eine Elektrode als Spannungssensor kapazitiv angekoppelt ist, sind ein als Ganzes mit 1 bezeichnetes Schnittstellenmodul und ein über eine Steckverbindung mit diesem verbindbares Spannungsanzeigegerät 2 vorgesehen. Letzteres weist, wie die Fig. 1 bis 4 zeigen, ein blockförmiges Gehäuse 3 auf, das aus einem elektrisch isolierenden Kunststoff mit hoher Isolationsfähigkeit besteht. Im Inneren des Gehäuses 3 befindet sich eine Leiterplatte 4, welche eine elektronische Schaltung 5 und eine Leuchtdiode 6 trägt. Zur Rückseite des Gehäuses 3 hin stehen von der Leiterplatte 4 zwei Steckerstifte 7 ab, welche über die Gehäuserückseite 8 überstehen. Über den einen Steckerstift 7 wird der elektronischen Schaltung 5 die vom Sensor erzeugte Spannung zugeführt. Über den anderen Steckerstift 7 wird eine Masseverbindung hergestellt.

Da, wie Fig. 2 zeigt, die Lichtaustrittsfläche der Leuchtdiode 6 gegenüber der Gehäusevorderseite 9 in das Gehäuse hinein zurückversetzt ist und außer der Lichtaustrittsfläche die Leuchtdiode 6 ebenso wie die elektronische Schaltung 5 vollständig in das das Gehäuse 3 bildende Isoliermaterial eingebettet sind, erstreckt sich von der Gehäusevorderseite 9 zur Lichtaustrittsfläche der Leuchtdiode 6 ein Kanal 10, welcher den Fremdlichteinfall reduziert und daher ein Erkennen des von der Leuchtdiode 6 erzeugten optischen Signals erleichtert.

Wie die Fig. 1 und 2 zeigen, sind die beiden Steckerstifte 7 auf einem Teil des über die Gehäuserückseite 8 überstehenden Abschnittes von je einer einstückig mit dem Gehäuse 3 ausgebildeten Materialpartie 11 umgeben. Deren an die Gehäuserückseite 8 anschließende Mantelfläche bildet eine leicht konische Dichtungsfläche, wobei die Verjüngung zu dem stark konischen Endabschnitt 11' hin erfolgt. Der Abstand der beiden zueinander parallel verlaufenden Steckerstifte 7 entspricht dem Abstand der Steckerstifte eines Eurosteckers.

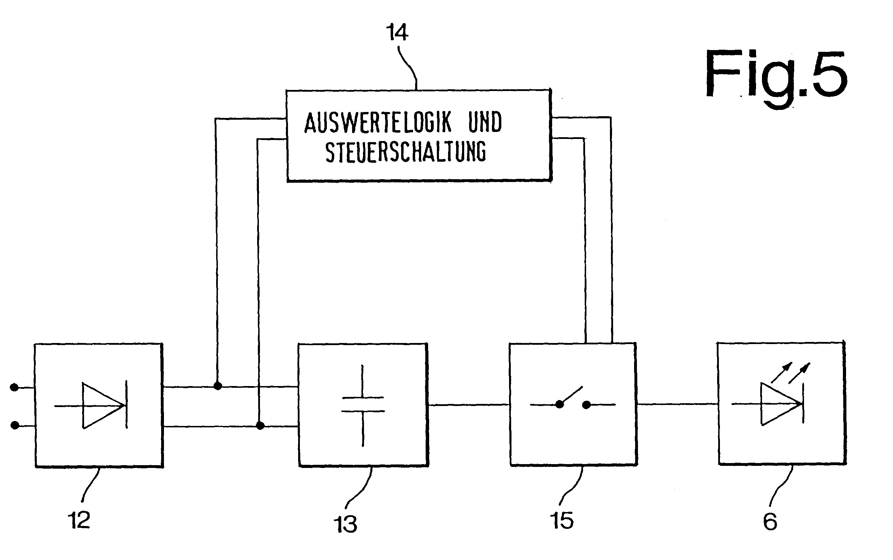

Die dem Spannungsanzeigegerät 2 über das Schnittstellenmodul 1 zugeführte Spannung wird, wie Fig. 5 zeigt, zunächst mittels eines Gleichrichters 12 gleichgerichtet. An den Ausgang des Gleichrichters 12 sind ein Energiespeicher 13 in Form eines Kondensators und eine elektronische Auswerte- und Steuerschaltung 14 angeschlossen, welche einen dem Energiespeicher nachgeschalteten, elektronischen Schalter 15 steuert. Wenn dieser elektronische Schalter 15 geschlossen ist, fließt die im Energiespeicher 13 gespeicherte Energie zu der Leuchtdiode 6.

Die elektronische Auswerte- und Steuerschaltung 14 steuert den elektronischen Schalter 15, der am Ende des Entladevorgangs des Energiespeichers 13 selbsttätig in den nichtleitenden Zustand übergeht, derart, daß er mit einer konstanten Frequenz, die im Ausführungsbeispiel 1 Hz beträgt, in den leitenden Zustand gebracht wird, wenn die Ausgangsspannung des Gleichrichters 12 einen vorgegebenen Grenzwert übersteigt. Dieser Grenzwert ist so gewählt, daß die Leuchtdiode 6 blinkt, wenn die Ausgangsspannung des Sensors und damit die Spannung des von ihm überwachten Leiters einen vorgegebenen Grenzwert übersteigt. Liegt die Spannung des überwachten Leiters über diesem Grenzwert, dann wirkt sich die Spannungshöhe nicht wie bei den bekannten Dauerspannungsanzeigegeräten auf deren Blinkfrequenz aus, sondern nur auf die Helligkeit des Lichtsignales. Je höher die Spannung des zu überwachenden Leiters ist, desto höher ist nämlich die Ausgangsspannung des Gleichrichters 12 und desto größer ist die Energiemenge, welche in einem Intervall zwischen zwei Einschaltungen des elektronischen Leiters 15 gesammelt wird.

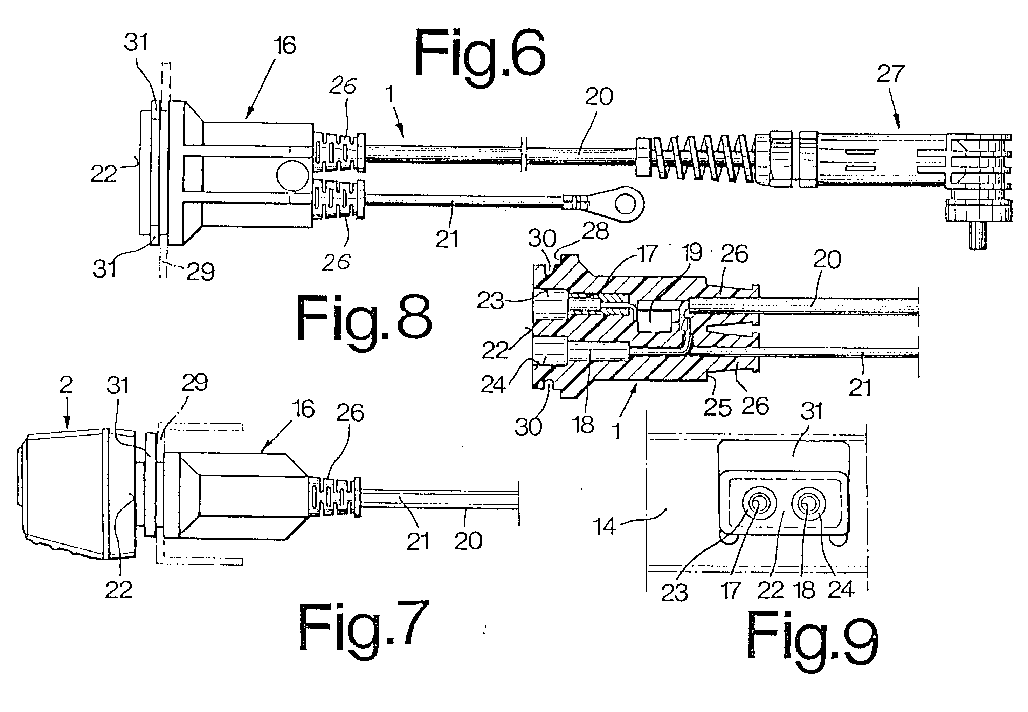

Das Schnittstellenmodul 1 weist ein geschlossenes Gehäuse 16 auf, in welches, wie Fig. 8 zeigt, zwei Steckbuchsen 17 und 18, eine Schaltungsanordnung 19, der eine Endabschnitt einer Koaxialleitung 20 und der eine Endabschnitt einer Erdungsleitung 21 eingebettet sind. Das Material, aus dem das Gehäuse 16 besteht und in das die genannten Teile eingebettet sind, ist ein Kunststoff mit hoher Isolationsfähigkeit. Wie das Gehäuse des Spannungsanzeigegerätes 2 ist das Gehäuse 16 ein Spritzgußteil aus einem thermoplastischen Kunststoff, der bei einer Temperatur unter 200°C und geringem Druck verarbeitet werden kann.

Da die beiden Steckbuchsen 17 und 18, die in ihrer Form und in ihrem Abstand an die beiden Steckerstifte 7 angepaßt sind, gegenüber der Frontseite 22 des Gehäuses 16 in dieses hineinversetzt angeordnet sind, sind zwei sich von der Frontseite 22 bis zu den Steckbuchsen 17 und 18 erstreckende Kanäle 23 bzw. 24 vorgesehen, deren Innenmantelfläche eine konische Anlagefläche für die Materialpartien 11 des Gehäuses 3 des Spannungsanzeigegerätes 2 bildet. Wenn die Steckerstifte 7 in die Steckbuchsen 17 und 18 eingesteckt sind, sind deshalb die Kanäle 23 und 24 elektrisch dicht verschlossen. Der Isolationswiderstand zwischen den Steckbuchsen 17 und 18 einerseits und der Außenseite des Gehäuses 16 beträgt deshalb auch unter ungünstigen Bedingungen, wie z.B. einem hohen Feuchtigkeitsgehalt der Umgebungsluft, mehrere Hundert Megaohm.

An die Rückseite 25 des Gehäuses 16 sind zwei elastische Tüllen 26 angeformt, welche dicht an der Koaxialleitung 20 und der Erdungsleitung 21 anliegen. Die Erdungsleitung 21, die an ihrem freien Ende mit einem Kabelschuh versehen ist, ist an dem im Gehäuse 16 eingebetteten Ende mit der einen Steckbuchse 18 sowie einem Massepunkt der im Gehäuse 16 eingebetteten Schaltungsanordnung 19 verbunden. Letztere enthält einen Überspannungsableiter. Daher kann, wenn dieser anspricht, der Strom über die Erdungsleitung 21 abfließen. Die Koaxialleitung 20 ist mit dem spannungführenden Pol der Schaltungsanordnung 19 und über diesen mit der Steckbuchse 17 verbunden. Die Koaxialleitung 20 hat eine bei der Auslegung der Schaltungsanordnung 19 berücksichtigte Länge, so daß ein definiertes Verhältnis zwischen der vom Sensor gelieferten Spannung und der am Gleichrichter 12 anliegenden Spannung vorhanden ist. Das freie Ende der Koaxialleitung 20 ist an einen Verbindungsstecker 27 angeschlossen, um in einfacher Weise eine Verbindung mit dem Sensor herstellen zu können.

Das Gehäuse 16 hat eine gegenüber der Frontseite 22 zurückversetzte, rahmenförmige Anlagefläche 28, die in Anlage an die eine Seite einer Trägerplatte 29 kommt, wenn der über die Anlagefläche 28 vorspringende, im Querschnitt rechteckförmige Teil des Gehäuses 16 in eine entsprechende Öffnung der Trägerplatte 29 eingeführt ist. Dieser vorspringende Teil weist in einem Abstand von der Anlagefläche 28, welcher der Dicke der Trägerplatte 29 entspricht, eine Nut 30 auf, in welche die Schenkel eines Befestigungsbügels 31 eingreifen. Dieser Befestigungsbügel 31 hält die Anlagefläche 28 in Anlage an der Rückseite der Trägerplatte 29. Da der Befestigungsbügel 39 nur auf den vorspringenden Teil des Gehäuses 16 aufgesteckt zu werden braucht, ist die Festlegung des Gehäuses 16 des Schnittstellenmoduls 1 an der Trägerplatte 29 äußerst einfach.

## Patentansprüche

1. Vorrichtung zur Anzeige der Spannung eines Leiters eines Hochspannungsenergieversorgungssystems, an den ein Sensor kapazitiv angekoppelt ist, mit einem Spannungsanzeigegerät (2), dem die Ausgangsspannung des Sensors über eine Schaltungsanordnung (19) zugeführt wird und das einen Energiespeicher (13) mit vorgeschaltetem Gleichrichter (12), einen elektrisch steuerbaren Schalter (15), der am Ende der Entladung des Energiespeichers (13) in den sperrenden Zustand Übergeht, und eine Blinksignale erzeugende Lichtquelle (6) aufweist, wobei die Lichtquelle (6) über den Schalter (15) mit dem Energiespeicher (13) verbunden ist, dadurch gekennzeichnet, daß für die Steuerung des Schalters (15) eine elektronische Auswerte- und Steuerschaltung (14) vorhanden ist, die eingangsseitig mit dem Ausgang des dem Energiespeicher (13) vorgeschalteten Gleichrichters (12) verbunden ist und oberhalb eines unteren Grenzwertes von dessen Ausgangsspannung den Schalter (15) mit einer gleichbleibenden Frequenz vom sperrenden Zustand in den leitenden Zustand umschaltet.

2. Vorrichtung nach Anspruch 1, dadurch gekennzeichnet, daß als Lichtquelle eine Leuchtdiode (6) vorhanden ist.

3. Vorrichtung nach Anspruch 1 oder 2, gekennzeichnet durch eine zweipolige Steckverbindung zwischen dem Spannungsanzeigegerät (2) und einem Schnittstellenmodul (1) der Vorrichtung, wobei die beiden Steckerstifte (7) am Spannungsanzeigegerät (2) und die beiden Steckbuchsen an einem geschlossenen Gehäuse (16) des Schnittstellenmoduls (1) vorhanden sind.

4. Vorrichtung nach Anspruch 3, dadurch gekennzeichnet, daß die Steckbuchsen (17, 18) des Schnittstellenmoduls (1) gegenüber der den Zugang zu ihnen gestattenden Frontseite (22) des Gehäuses (16) zurückversetzt im Gehäuse (16) angeordnet sind und je ein Kanal (23, 24) sich von der Frontseite (22) zu den Steckbuchsen (17, 18) erstreckt, dessen Wandfläche eine sich zur Steckbuchse (17, 18) verjüngende, konische Dichtungsfläche bildet, an der bei hergestellter Steckverbindung eine entsprechend konische Außenmantelfläche einer den Steckerstift (7) auf einem Teil seiner Länge umgebenden Materialpartie (11) aus Isoliermaterial unter Bildung einer elektrischen Dichtung anliegt.

5. Vorrichtung nach Anspruch 4, dadurch gekennzeichnet, daß die eine Steckbuchse (17) mit dem im Betrieb spannungführenden Ausgang der im Gehäuse (16) des Schnittstellenmoduls (1) enthaltenen Schaltungsanordnung (19) und die andere Steckbuchse (18) mit einem Massepunkt dieser Schaltungsanordnung (19) verbunden ist.

6. Vorrichtung nach Anspruch 5, dadurch gekennzeichnet, daß mit dem Gehäuse (16) des Schnittstellenmoduls (1) das eine Ende eines Koaxialkabels (20) fest und dicht verbunden ist, das den Eingang der Schaltungsanordnung (19) mit einem Stecker (27) verbindet, der in eine Steckbuchse einsteckbar ist, welche mit dem durch eine Elektrode gebildeten Sensor verbunden ist.

7. Vorrichtung nach Anspruch 6, gekennzeichnet durch eine vom Gehäuse (16) des Schnittstellenmoduls (1) wegführende Erdungsleitung (21), die mit einem Massepunkt der Schaltungsanordnung (19) verbunden ist.

8. Vorrichtung nach einem der Ansprüche 3 bis 7, dadurch gekennzeichnet, daß die Steckbuchsen (17, 18), die Schaltungsanordnung (19) und der eine Endabschnitt jeder vorhandenen, vom Gehäuse (16) des Schnittstellenmoduls (1) wegführenden Leitung (20, 21) in das Isoliermaterial dieses Gehäuses (16) eingebettet sind.

9. Vorrichtung nach einem der Ansprüche 1 bis 8, dadurch gekennzeichnet, daß die elektrischen Bauelemente des Spannungsanzeigegerätes (2) unter Freilassung der Lichtaustrittsfläche der Lichtquelle (6) sowie das eine Ende der Steckerstifte (7) in ein das Gehäuse (3) des Spannungsanzeigegerätes (2) bildendes Isoliermaterial eingebettet sind.

10. Vorrichtung nach Anspruch 8 oder 9, dadurch gekennzeichnet, daß jedes vorhandene Gehäuse (3, 16) ein Spritzgußteil aus einem thermoplastischen Kunststoff ist.

11. Vorrichtung nach Anspruch 9, dadurch gekennzeichnet, daß auf die Lichtaustrittsfläche der Lichtquelle (6), die im Inneren des Gehäuses (3) des Spannungsanzeigegerätes (2) liegt, ein Fremdlicht abschirmender Kanal (10) ausgerichtet ist, der sich von der Frontseite dieses Gehäuses (3) bis zur Lichtaustrittsfläche erstreckt.

## Claims

1. Device for displaying the voltage of a conductor of a high-voltage power supply system, to which conductor a sensor is coupled in a capacitive manner, having a voltage display unit (2), to which the output voltage of the sensor is supplied via a circuit arrangement (19) and which has a power store (13) having a rectifier (12) connected upstream, an electrically controllable switch (15), which passes into the blocking state when the discharging of the power store (13) is complete, and a light source (6) generating flashing signals, wherein the light source (6) is connected via the switch (15) to the power store (13), characterised in that, for the control of the switch (15), an electronic evaluation and control circuit (14) is present which is connected at the input side to the output of the rectifier (12) connected upstream of the power store (13) and, above a lower limit value of the output voltage of the rectifier, switches over the switch (15) with a constant frequency from the blocking state into the conductive state.

2. Device according to Claim 1, characterised in that a light-emitting diode (6) is present as the light source.

3. Device according to Claim 1 or 2, characterised by a two-pole plug connection between the voltage display unit (2) and an interface module (1) of the device, wherein the two plug pins (7) are present on the voltage display unit (2) and the two plug sockets are present on a closed housing (16) of the interface module (1).

4. Device according to Claim 3, characterised in that the plug sockets (17,18) of the interface module (1) are arranged in the housing (16) so that they are set back relative to the housing's front side (22) which allows access to them, and a respective channel (23,24) extends from the front side (22) to each of the plug sockets (17,18) and its wall face forms a conical sealing face which tapers towards the plug socket (17,18) and which, when the plug connection has been produced, is abutted, to form an electrical seal, by a correspondingly conical outer surface of a material part (11) which surrounds the plug pin (7) over part of its length and which consists of insulating material.

5. Device according to Claim 4, characterised in that one plug socket (17) is connected to the output, which conducts voltage in use, of the circuit arrangement (19) which is contained in the housing (16) of the interface module (1), and the other plug socket (18) is connected to an earth point of that circuit arrangement (19).

6. Device according to Claim 5, characterised in that that end of a coaxial cable (20) which connects the input of the circuit arrangement (19) to a plug (27), which can be plugged into a plug socket connected to the sensor formed by an electrode, is connected in a secure and sealed manner to the housing (16) of the interface module (1).

7. Device according to Claim 6, characterised by an earthing line (21) which leads away from the housing (16) of the interface module (1) and which is connected to an earth point of the circuit arrangement (19).

8. Device according to any one of Claims 3 to 7, characterised in that the plug sockets (17, 18), the circuit arrangement (19) and one end portion of each line (20, 21) present and leading away from the housing (16) of the interface module (1) are embedded in the insulating material of this housing (16).

9. Device according to any one of Claims 1 to 8, characterised in that the electrical components of the voltage display unit (2) are embedded in an insulating material forming the housing (3) of the voltage display unit (2), whilst leaving the light outlet face of the light source (6) free, and one end of the plug pins (7) is also embedded in that material.

10. Device according to Claim 8 or 9, characterised in that each housing (3, 16) present is an injection-moulded part of thermoplastic plastics material.

11. Device according to Claim 9, characterised in that a channel (10) which protects from foreign light is aligned on the light outlet face of the light source (6) located in the interior of the housing (3) of the voltage display unit (2) and extends from the front side of this housing (3) as far as the light outlet face.

## Revendications

1. Dispositif pour afficher la tension d'un conducteur d'un système d'alimentation en énergie à haute tension, auquel un capteur est couplé de façon capacitive, comportant un appareil (2) d'affichage de la tension, auquel la tension de sortie du capteur est envoyée par l'intermédiaire d'un montage (19) et qui comporte un accumulateur d'énergie (13), en amont duquel est branché un redresseur (12), un interrupteur commandable électriquement (15) qui, à la fin de la décharge de l'accumulateur d'énergie (13), passe à l'état bloqué, et une source de lumière (6) qui produit des signaux clignotants, la source de lumière (6) étant reliée à l'accumulateur d'énergie (13) par l'intermédiaire de l'interrupteur (15), caractérisé en ce que pour la commande de l'interrupteur (15) il est prévu un circuit électronique d'exploitation et de commande (14), qui est relié, côté entrée, à la sortie du redresseur (12) branché en amont de l'accumulateur d'énergie (13) et qui, au-dessus d'une valeur limite inférieure de sa tension de sortie, commute l'interrupteur (15), avec une fréquence constante, de l'état bloqué à l'état conducteur.

2. Dispositif selon la revendication 1, caractérisé en ce qu'il est prévu comme source de lumière une diode à luminescence.

3. Dispositif selon la revendication 1 ou 2, caractérisé par un connecteur bipolaire disposé entre l'appareil (2) d'affichage de la tension et un module d'interface (1) du dispositif, les deux broches de connexion (7) étant présentes sur l'appareil d'affichage de la tension et les deux douilles d'enfichage étant prévues sur un boîtier fermé (16) du module d'interface (1).

4. Dispositif selon la revendication 3, caractérisé en ce que les douilles d'enfichage (17,18) du module d'interface (1) sont disposées en étant décalées en retrait par rapport à la face avant (22) du boîtier (16), qui permet l'accès à ces douilles, et qu'un canal respectif (23, 24) s'étend depuis la face avant (22) jusqu'aux douilles d'enfichage (17,18), canal dont la surface de paroi forme une surface conique d'étanchéité, qui se rétrécit en direction de la douille d'enfichage (17,18) et contre laquelle une surface enveloppe extérieure conique correspondante d'une partie (11) formée d'un matériau isolant, qui entoure la broche de connexion (7) sur une partie de sa longueur, s'applique en établissant une étanchéité électrique.

5. Dispositif selon la revendication 4, caractérisé en ce qu'une douille d'enfichage (17) est reliée à la sortie, qui délivre la tension en fonctionnement, du montage (19) contenu dans le boîtier (16) du module d'interface (1) et que l'autre douille d'enfichage (18) est reliée à un point de masse de ce montage (19).

6. Dispositif selon la revendication 5, caractérisé en ce qu'au boîtier (16) du module d'interface (1) est reliée de façon fixe et étanche une extrémité d'un câble coaxial (20), qui relie l'entrée du montage (19) à un connecteur (27), qui peut être enfiché dans une douille d'enfichage, qui est reliée au capteur formé par une électrode.

7. Dispositif selon la revendication 6, caractérisé par une ligne de mise à la terre (21), qui s'étend à partir du boîtier (16) du module d'interface (1) et est reliée à un point de masse du montage (19).

8. Dispositif selon l'une des revendications 3 à 7, caractérisé en ce que les douilles d'enfichage (17,18), le montage (19) et une section d'extrémité de chaque ligne présente (20,21), qui part du boîtier (16) du module d'interface (1), sont enchâssées dans le matériau isolant du boîtier (16).

9. Dispositif selon l'une des revendications 1 à 8, caractérisé en ce que les composants électriques de l'appareil (2) d'affichage de la tension sont enchâssés, tout en laissant dégagées une surface de sortie de la lumière de la source de lumière (6) ainsi qu'une extrémité des broches de connexion (7), dans un moteur isolant qui forme le boîtier (3) de l'appareil (2) d'affichage de la tension.

10. Dispositif selon la revendication 8 ou 9, caractérisé en ce que chaque boîtier présent (3,16) est une pièce moulée par injection en matière thermoplastique.

11. Dispositif selon la revendication 9, caractérisé en ce qu'un canal (10) est dirigé sur la surface de sortie de la lumière de la source de lumière (6), qui est située à l'intérieur du boîtier (3) de l'appareil (2) d'affichage de la tension, le canal réalisant une étanchéité vis-à-vis de la lumière extérieure et s'étendant depuis la face avant de ce boîtier (3) jusqu'à la surface de sortie de la lumière.
